(19) Europäisches Patentamt / European Patent Office / Office européen des brevets

(11) **EP 3 838 498 B1**

(12) # EUROPÄISCHE PATENTSCHRIFT

(45) Veröffentlichungstag und Bekanntmachung des Hinweises auf die Patenterteilung:
**26.07.2023 Patentblatt 2023/30**

(21) Anmeldenummer: **20212436.8**

(22) Anmeldetag: **08.12.2020**

(51) Internationale Patentklassifikation (IPC):
*H02H 6/00* (2006.01)    *G01K 7/16* (2006.01)
*B25F 5/00* (2006.01)

(52) Gemeinsame Patentklassifikation (CPC):
**B25F 5/00; G01K 7/16; H02H 6/005**

(54) **ELEKTROWERKZEUG, MESSEINRICHTUNG UND VERFAHREN ZUM BETRIEB EINES ELEKTROWERKZEUGS**

ELECTRIC TOOL, MEASURING DEVICE AND METHOD FOR OPERATING AN ELECTRIC TOOL

OUTIL ÉLECTRIQUE, AGENCEMENT DE MESURE ET PROCÉDÉ DE FONCTIONNEMENT D'UN OUTIL ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.12.2019 DE 102019134777**

(43) Veröffentlichungstag der Anmeldung:
**23.06.2021 Patentblatt 2021/25**

(73) Patentinhaber: **Metabowerke GmbH**
**72622 Nürtingen (DE)**

(72) Erfinder: **Prescher, Benjamin**
**81369 München (DE)**

(74) Vertreter: **Schmid, Wolfgang**
**Lorenz & Kollegen**
**Patentanwälte Partnerschaftsgesellschaft mbB**
**Alte Ulmer Strasse 2**
**89522 Heidenheim (DE)**

(56) Entgegenhaltungen:
EP-A1- 0 720 266          EP-B1- 0 414 052
DE-A1-102014 000 654    DE-U1-202019 101 146

EP 3 838 498 B1

**Beschreibung**

Die Erfindung betrifft ein Verfahren zum Betrieb eines Elektrowerkzeugs gemäß dem Oberbegriff des Anspruchs 1.

Die Erfindung betrifft ferner ein Computerprogrammprodukt zur Durchführung eines Verfahrens zum Betrieb eines Elektrowerkzeugs.

Die Erfindung betrifft außerdem eine Messeinrichtung zur Bestimmung eines Wicklungswiderstands einer Wicklung eines Elektromotors eines Elektrowerkzeugs, gemäß dem Oberbegriff des Anspruchs 14.

Die Erfindung betrifft schließlich auch ein Elektrowerkzeug.

Als Elektrowerkzeuge werden nachfolgend sowohl handgeführte Elektrowerkzeuge wie Bohrmaschinen, Winkelschleifer oder dergleichen, als auch im Betrieb feststehende, d. h. stationäre oder halbstationäre Geräte wie Tischkreissägen oder dergleichen, verstanden. Elektrowerkzeuge und Verfahren zu deren Betrieb sind aus dem allgemeinen Stand der Technik ausreichend bekannt.

Bekanntermaßen nimmt die Temperatur einer Wicklung eines Elektromotors unter Last zu. Um den Motor vor einer möglichen Überhitzung und somit einer Schädigung seiner elektrischen und mechanischen Komponenten zu schützen ist es bekannt, die Temperatur des Elektromotors zu bestimmen oder diese zumindest zu schätzen.

Beispielsweise offenbart die DE 602 23 466 T2 ein System zum Schätzen einer Temperatur einer elektrischen Maschine, umfassend eine Steuereinrichtung und einen Temperatursensor, der mit der Steuereinrichtung funktional verbunden ist und der ein Temperatursignal sendet. Die Steuereinrichtung vermag schließlich einen Temperaturschätzprozess auszuführen, um die Temperatur der elektrischen Maschine zu schätzen.

Die Verwendung eines Temperatursensors erhöht allerdings die Herstellungskosten des Elektrowerkzeugs.

Als Folge der Temperaturerhöhung einer Wicklung des Elektromotors ändert sich der Wicklungswiderstand der Wicklung, wodurch wiederum Regelparameter des Elektromotors beeinflusst werden. Für eine optimale Reglerauslegung ist allerdings die Kenntnis des tatsächlichen Werts des Wicklungswiderstands von erheblicher Bedeutung.

Um den Wicklungswiderstand in Abhängigkeit der Ist-Temperatur des Elektromotors zu überwachen ist es bekannt, den Wicklungswiderstand auf Grundlage der mittels des Temperatursensors erfassten Temperatur zu berechnen. Der Umweg über die Temperaturmessung kann allerdings zu vergleichsweise ungenauen Ergebnissen führen.

In Druckschrift EP 0 414 052 B1 wird eine Anordnung zur Messung der Wicklungstemperatur von elektrischen Maschinen unter Verzicht auf Temperatursensoren vorgeschlagen, um eine Temperaturmessung mit hoher Genauigkeit zu ermöglichen. Hierzu wird zusätzlich zur eigentlichen Versorgung des Elektromotors in einer oder in mehreren Phasen eine nicht netzfrequente, bekannte Spannungskomponenten zu der Netzspannung addiert. Der entsprechende Strom in der Wicklung des Motors wird schließlich von einer Messeinheit gemessen. Auf diese Weise kann während des Betriebs der Maschine der augenblickliche Wicklungsleitwert erfasst werden, aus dem schließlich bei bekannten Temperaturkoeffizienten des Wicklungsmaterials die augenblickliche mittlere Wicklungstemperatur ableitbar ist.

Die Auswertungsalgorithmen des Messverfahrens zur Bestimmung des Wicklungsleitwerts sind in der EP 0 414 052 B1 allerdings vergleichsweise rudimentär und auch nicht optimal für alle Anwendungen gleichermaßen geeignet. Das Messverfahren der EP 0 414 052 B1 ist insbesondere für die Verwendung in Anwendungen, bei denen sich mitunter auch sehr plötzlich hohe und geringe Lastströme abwechseln können, wie beispielsweise bei Elektrowerkzeugmaschinen der Fall, nicht ausreichend verlässlich.

Die gattungsgemäße EP 0 720 266 A1 offenbart die Merkmale des Oberbegriffs des Anspruchs 1 bzw. des Anspruchs 14 und betrifft einen ähnlichen Gegenstand wie die EP 0 414 052 B1, eignet sich jedoch zur Erfassung der Wicklungstemperatur einer Motorwicklung einer Elektrowerkzeugmaschine.

In Anbetracht des bekannten Stands der Technik besteht die Aufgabe der vorliegenden Erfindung darin, ein Verfahren zum Betrieb eines Elektrowerkzeugs bereitzustellen, mit dem vorzugsweise kostengünstig und mit hoher Genauigkeit der Wicklungswiderstand einer Wicklung eines Elektromotors bestimmbar ist.

Der vorliegenden Erfindung liegt auch die Aufgabe zugrunde, ein vorteilhaftes Computerprogrammprodukt zur Ausführung eines entsprechenden Verfahrens zum Betrieb eines Elektrowerkzeugs bereitzustellen Schließlich ist es auch Aufgabe der Erfindung, eine Messeinrichtung bereitzustellen, mit der vorzugsweise kostengünstig und mit hoher Genauigkeit ein Wicklungswiderstand einer Wicklung eines Elektromotors bestimmbar ist. Außerdem ist es Aufgabe der Erfindung, ein verbessertes Elektrowerkzeug bereitzustellen.

Die Aufgabe wird für das Verfahren mit den in Anspruch 1 aufgeführten Merkmalen gelöst. Hinsichtlich des Computerprogrammprodukts wird die Aufgabe durch die Merkmale des Anspruchs 13 gelöst. Bezüglich der Messeinrichtung wird die Aufgabe durch die Merkmale des Anspruchs 14 und betreffend das Elektrowerkzeug durch Anspruch 15 gelöst.

Die abhängigen Ansprüche und die nachfolgend beschriebenen Merkmale betreffen vorteilhafte Ausführungsformen und Varianten der Erfindung.

Es ist ein Verfahren zum Betrieb eines Elektrowerkzeugs vorgesehen, wonach eine Messeinrichtung einen Wicklungswiderstand einer Wicklung eines Elektromotors des Elektrowerkzeugs bestimmt.

Erfindungsgemäß ist vorgesehen, dass eine Prüfsignalquelle die Wicklung während des Betriebs des Elektromotors mit einem Prüfsignal beaufschlagt, wobei eine Messeinheit wenigstens einen Messwert als Reaktion der Wicklung auf das Prüfsignal erfasst. Eine Steuereinrichtung bestimmt schließlich den Wicklungswiderstand unter Berücksichtigung des Messwerts.

Das Prüfsignal ist vorzugsweise ein Prüfstrom. Durch das Beaufschlagen der Wicklung des Elektromotors mit dem Prüfsignal, insbesondere dem Prüfstrom, erhöht sich der Spannungsabfall über die Wicklung messbar. Diese Erhöhung kann schließlich von der Messeinheit erfasst werden.

Vorzugsweise berücksichtigt die Steuereinrichtung neben dem Messwert auch das (bekannte) Prüfsignal zur Bestimmung des Wicklungswiderstands. Die Steuereinrichtung kann den Wicklungswiderstand insbesondere unter Berücksichtigung der Amplitude des Prüfsignals und der Amplitude des Messwerts bestimmen.

Erfindungsgemäß kann die Notwendigkeit eines externen, zusätzlichen Temperatursensors entfallen. Hierdurch können der Verkabelungs- und Produktionsaufwand und infolge die Herstellungskosten des Elektrowerkzeugs vorteilhaft verringert sein.

Dadurch, dass eine Bestimmung des Wicklungswiderstands erfindungsgemäß ohne Umweg über eine zunächst erfasste Ist-Temperatur unmittelbar erfolgen kann, kann der Wicklungswiderstand mit höherer Genauigkeit und außerdem auch schneller bzw. kontinuierlicher erfassbar sein.

Erfindungsgemäß ist vorgesehen, dass die Prüfsignalquelle das Prüfsignal mit einem alternierenden Verlauf erzeugt. Das Prüfsignal kann eine positive Halbwelle und eine negative Halbwelle aufweisen.

Ein alternierender Verlauf des Prüfsignals kann auf vorteilhafte Weise Gleichtaktstörungen und Ungenauigkeiten der im ausgeschalteten Zustand des Elektromotors bestimmten Motorparameter (z. B. Induktivitäten und Maschinenfluss) minimieren.

Das alternierende Prüfsignal kann vorzugsweise mit einer Frequenz von 1,0 Hz bis 1,0 MHz, besonders bevorzugt mit einer Frequenz von 2,0 Hz bis 2,0 kHz, ganz besonders bevorzugt mit einer Frequenz von 50,0 Hz bis 1,0 kHz, beispielsweise 100,0 Hz, erzeugt werden. Grundsätzlich können aber beliebige Frequenzen vorgesehen sein.

Vorzugsweise kann vorgesehen sein, dass die Prüfsignalquelle das Prüfsignal mit einem rechteckigen Verlauf erzeugt. Durch die Verwendung eines Prüfsignals in Rechteckform, insbesondere mit geringer Frequenz von nur wenigen Hertz, können für die Messung quasistationäre Zustände erreicht werden. Hierdurch können die erforderlichen Berechnungen und Messungen vereinfacht sein.

Grundsätzlich kann allerdings auch ein sinusförmiger oder ein sonstiger Verlauf des Prüfsignals vorgesehen sein.

In einer Ausgestaltung der Erfindung kann vorgesehen sein, dass die Prüfsignalquelle die Wicklung nicht kontinuierlich mit dem Prüfsignal beaufschlagt, sondern beispielsweise nur während definierter Zeitabschnitte während des Betriebs des Elektromotors.

Vorzugsweise erstrecken sind die definierten Zeitabschnitte, in denen die Wicklung mit dem Prüfsignal beaufschlagt wird, nur über möglichst kurze Zeiträume, insbesondere nur über Zeiträume einiger Millisekunden. Hierdurch kann aufgrund der thermischen Trägheit der Maschine eine durch das Prüfsignal hervorgerufene Erwärmung vernachlässigt werden.

Gemäß einer Weiterbildung der Erfindung kann vorgesehen sein, dass die Prüfsignalquelle das Prüfsignal auf ein an der Wicklung anliegendes Betriebssignal aufmoduliert.

Der Elektromotor des Elektrowerkzeugs kann vorzugsweise als Drehstrommaschine ausgebildet sein. Zur Steuerung bzw. Regelung des Elektromotors kann vorzugsweise eine feldorientierte Regelung (auch als "Vektorregelung" bekannt) vorgesehen sein.

Vorzugsweise ist für den Betrieb des Elektromotors keine Blockkommutierung vorgesehen. Grundsätzlich kann sich die Erfindung allerdings auch zur Verwendung in einem Elektrowerkzeug eignen, in dem zur Steuerung des Elektromotors eine Blockkommutierung vorgesehen ist.

Das Prüfsignal, insbesondere ein Prüfstrom, kann in eine Ständerwicklung des Elektromotors zur Erfassung des Wicklungswiderstands der Ständerwicklung eingeprägt werden.

Gemäß einer Weiterbildung der Erfindung kann vorgesehen sein, dass die Prüfsignalquelle das Prüfsignal ausschließlich in die d-Achse eines d/q-Koordinatensystems einprägt. Hierbei kann es sich um ein rotorfestes Koordinatensystem eines Permanentmagnet-Synchronmotors handeln.

Hierdurch kann ein unerwünschtes Pendelmoment durch Beeinflussung der q-Komponente ausgeschlossen werden.

Zur Bestimmung des Wicklungswiderstands kann die Steuereinrichtung die Ständerstrangspannungsgleichung im d/q-Koordinatensystem auswerten:

$$u_d = R_S \cdot i_d + L_d \cdot \frac{di_d}{dt} - \omega_{el} \cdot L_q \cdot i_q,$$

mit der Strangspannung $u_d$, den Strangströmen $i_d$ und $i_q$, dem Wicklungswiderstand Rs, den Ständerinduktivitäten $L_d$ und $L_q$ und der Winkelgeschwindigkeit $\omega_{el}$.

Es kann vorgesehen sein, dass die Messeinheit den wenigstens einen Messwert erst nach dem Einschwingen des Prüfsignals erfasst. Somit kann beispielsweise eine gewisse Totzeit abgewartet werden, bevor die Messung erfolgt. Unter stationären Zuständen, insbesondere bei Verwendung eines Prüfstroms in Rechteckform mit geringer Frequenz und bei Messung erst nach dem Einschwingen des Prüfsignals, kann sich die vorstehend genannte Gleichung vereinfachen zu:

$$u_d = R_S \cdot i_d - \omega_{el} \cdot L_q \cdot i_q$$

Nach dem Einschwingvorgang des Prüfsignals können von der Messeinheit mehrere Strom- und Spannungsmesswerte erfasst werden. Zur Erfassung bzw. zur digitalen Weiterbearbeitung der Messwerte kann beispielsweise ein Analog-Digital-Wandler vorgesehen sein.

In einer Weiterbildung der Erfindung kann vorgesehen sein, dass die Messeinheit wenigstens einen Spannungs-Messwert und wenigstens einen Strom-Messwert erfasst.

Vorzugsweise führt die Messeinheit eine Phasenspannungsmessung und eine Phasenstrommessung durch.

Erfindungsgemäß ist vorgesehen, dass die Messeinheit für jede Halbwelle des alterierenden Prüfsignals zumindest einen einzelnen Messwert oder einen aus mehreren einzelnen Messwerten gemittelten Messwert erfasst, insbesondere jeweils einen gemittelten Spannungs-Messwert ($\overline{u}_{d,pos}$ und $\overline{u}_{d,neg}$) und einen gemittelten Strom-Messwert ($\overline{i}_{d,pos}$ und $\overline{i}_{d,neg}$). Vorzugsweise kann durch Mittelung mehrerer Messwerte für jede Halbwelle ein mittlerer Prüfstrom ermittelt werden (nachfolgend beispielhaft für ein Intervall im Zeitraum $t_1$ bis $t_2$ für die positive Halbwelle und für ein Intervall im Zeitraum $t_3$ bis $t_4$ für die negative Halbwelle dargestellt):

$$\overline{i}_{d,pos} = \frac{1}{n} \cdot \int_{t1}^{t2} i_d(t)dt \quad , \quad \overline{i}_{d,neg} = \frac{1}{n} \cdot \int_{t3}^{t4} i_d(t)dt \ .$$

Die Mittelung der Messwerte kann auch von der Steuereinrichtung durchgeführt werden.

Erfindungsgemäß ist weiter vorgesehen, dass die Steuereinrichtung oder die Messeinheit für die Bestimmung des Wicklungswiderstand einen differentiellen Messwert aus den für die jeweilige Halbwelle erfassten einzelnen Messwerten oder gemittelten Messwerten berechnet, insbesondere einen differentiellen Spannungs-Messwert ($\overline{u}_{d,pos}$ - $\overline{u}_{d,neg}$) und einen differentiellen Strom-Messwert ($\overline{i}_{d/q,pos}$ - $\overline{i}_{d/q,neg}$).

Beispielsweise kann nach Messung von zwei Halbwellen des alternierenden Prüfsignals eine Auswertung der Messdaten vorgesehen sein (eine Auswertung zweier aufeinander folgender Halbwellen wird nachfolgend auch als "Messintervall" bezeichnet). Aus der Differenz der sich ergebenden Strangspannungsgleichung für die positive und für die negative Halbwelle und unter Annahme einer konstanten Drehzahl im Messintervall kann schließlich von der Steuereinrichtung oder von der Messeinheit der Wicklungswiderstand des Messintervalls n bestimmt werden:

$$R_{S,n} = \frac{1}{\overline{i}_{d,pos} - \overline{i}_{d,neg}} \cdot \left[ \overline{u}_{d,pos} - \overline{u}_{d,neg} + \omega_{el} \cdot L_q \cdot \left( \overline{i}_{q,pos} - \overline{i}_{q,neg} \right) \right]$$

Vorzugsweise kann sich die Messung schließlich über mehrere Messintervalle erstrecken. Nach einer PT1-Filterung bzw. Tiefpassfilterung / Mittelwertbildung der einzelnen Wicklungswiderstände $R_{S,n}$ der mehreren Messintervalle n kann das finale Ergebnis für den Wicklungswiderstand Rs ausgegeben werden.

In einer Weiterbildung der Erfindung kann vorgesehen sein, dass die Steuereinrichtung auf Grundlage des Wicklungswiderstands einen oder mehrere Regelparameter berechnet, vorzugsweise eine Zeitkonstante der Ständerwicklung.

Die Steuerung des Elektromotors des Elektrowerkzeugs kann somit verbessert und effizienter sein.

Besonders bevorzugt kann der Wicklungswiderstand Rs zur Bestimmung der elektrischen Zeitkonstante der Ständerwicklung ($\tau$ = L/R) herangezogen werden, welche für Verfahren der Regelungstechnik, wie beispielsweise die Berechnung von Stromregelparametern, vorteilhaft ist.

In einer vorteilhaften Weiterbildung der Erfindung kann vorgesehen sein, dass die Steuereinrichtung auf Grundlage des Wicklungswiderstands eine Ist-Temperatur des Elektromotors berechnet.

Unter Kenntnis des verwendeten Wicklungsmaterials und dessen Widerstands bei einer definierten Temperatur kann über den erfindungsgemäß bestimmten Wicklungswiderstand auf die Wicklungstemperatur zurückgeschlossen werden. Der Wicklungswiderstand ist dabei annähernd proportional zu der Temperatur und kann durch Umstellen der folgenden Gleichung beschrieben werden:

$$R_S = R_{S0} \cdot [1 + \alpha \cdot (T_{IST} - T_0)],$$

mit dem bekannten Wicklungswiderstand bei der Temperatur $T_0$, der zu bestimmenden Ist-Temperatur $T_{IST}$ und dem materialabhängigen Temperaturkoeffizient $\alpha$ in 1/°C.

Auf vorteilhaft Weise kann somit eine indirekte Temperaturbestimmung der Motorwicklung während des Betriebs des Elektrowerkzeugs bzw. des Elektromotors erfolgen.

Durch die Berechnung der Ist-Temperatur kann vorteilhaft eine Überwachung der Temperatur des Elektromotors bzw. des Elektrowerkzeugs ohne die Notwendigkeit eines zusätzlichen Temperatursensors erfolgen.

In einer vorteilhaften Weiterbildung der Erfindung kann vorgesehen sein, dass die Steuereinrichtung eine Temperaturdifferenz zwischen der Ist-Temperatur und einer zu erwartenden Nominaltemperatur erfasst.

Wenn beispielsweise die gemessene Ist-Temperatur deutlich über der zu erwartenden Nominaltemperatur liegt, kann von einem Fehlerzustand, insbesondere von einer Verschmutzung des Elektrowerkzeugs oder einer andersartigen Behinderung eines Kühlluftstroms ausgegangen werden. Schließlich können gegebenenfalls geeignete Gegenmaßnahmen ergriffen werden. Somit kann auf vorteilhafte Weise die Lebensdauer des Elektrowerkzeugs erhöht werden.

In einer vorteilhaften Weiterbildung der Erfindung kann vorgesehen sein, dass in Abhängigkeit der Temperaturdifferenz eine Meldung für einen Benutzer des Elektrowerkzeugs ausgegeben wird.

Somit kann der Benutzer des Elektrowerkzeugs über den möglicherweise problematischen, beispielsweise verschmutzten oder verstaubten Zustand des Elektrowerkzeugs informiert werden, so dass dieser geeignete Gegenmaßnahmen ergreifen kann, um den Zustand zu beenden.

Beispielsweise kann eine optische Meldung ausgegeben werden. Dies ermöglicht auf sehr einfache Weise eine Übermittlung des kritischen Zustands des Elektrowerkzeugs an dessen Nutzer.

Alternativ oder zusätzlich kann vorgesehen sein, dass eine akustische Meldung ausgegeben wird. Auch auf diese Weise kann der Nutzer über den problematischen Zustand des Elektrowerkzeugs informiert werden.

Eine weitere Möglichkeit besteht darin, dass eine Meldung über eine drahtlose Schnittstelle an ein mobiles Endgerät ausgegeben wird. Ein solches mobiles Endgerät kann die Warnung auf unterschiedliche Art und Weise an den Benutzer weitergeben.

In einer Weiterbildung der Erfindung kann vorgesehen sein, dass das Elektrowerkzeug abgeschaltet wird, wenn die Temperaturdifferenz einen vordefinierten Schwellenwert überschreitet.

Insbesondere auch durch diese Maßnahme kann auf vorteilhafte Weise eine Beschädigung des Elektrowerkzeugs verhindert werden.

Die zu erwartende Nominaltemperatur kann vorzugsweise mittels eines Rechenmodells aus den Betriebsparametern und/oder Konstanten des Elektromotors berechnet werden. Ein solches Rechenmodell stellt eine einfache Möglichkeit zur Berechnung der durch den Betrieb des Elektrowerkzeugs zu erwartenden Temperatur dar.

Besonders vorteilhaft kann es sein, wenn die Betriebsparameter und/oder Konstanten des Elektromotors eine Drehzahl, eine Stromstärke und/oder einen elektrischen Widerstand umfassen. Diese Betriebsparameter des Elektromotors gewährleisten eine sehr hohe Genauigkeit bei der Berechnung der zu erwartenden Nominaltemperatur.

Es sei erwähnt, dass das Aufmodulieren des Prüfsignals während des Betriebs des Elektromotors nicht unbedingt kontinuierlich notwendig ist. Vielmehr kann eine Aktualisierung des Wicklungswiderstandswertes durch den Benutzer oder einen Algorithmus zu definierten Zeiten erfolgen.

Es kann vorgesehen sein, dass das erfindungsgemäße Verfahren zur Bestimmung jeder Wicklung eines mehrere Wicklungen aufweisenden Elektromotors verwendet wird. Somit kann für jede der Wicklungen der Wicklungswiderstand erfindungsgemäß bestimmt werden. Es kann aber gegebenenfalls bereits ausreichend sein, lediglich den Wicklungswiderstand einer der Wicklungen des Elektromotors zu bestimmen, da in der Regel angenommen werden kann, dass die Ist-Temperatur und damit auch die Wicklungswiderstände aller Wicklungen einen ähnlichen Verlauf aufweisen.

Die Erfindung betrifft auch ein Computerprogrammprodukt mit Programmcodemitteln, um ein Verfahren gemäß den vorstehenden und nachfolgenden Ausführungen durchzuführen, wenn das Programm auf einer Steuereinheit eines Elektrowerkzeugs ausgeführt wird.

Die Steuereinheit kann der Steuereinrichtung entsprechen. Die Steuereinheit kann allerdings auch unabhängig von der Steuereinrichtung sein.

Die Steuereinrichtung bzw. die Steuereinheit kann als Mikroprozessor ausgebildet sein. Anstelle eines Mikroprozessors kann auch eine beliebige weitere Einrichtung zur Implementierung der Steuereinrichtung bzw. der Steuereinheit vorgesehen sein, beispielsweise eine oder mehrere Anordnungen diskreter elektrischer Bauteile auf einer Leiterplatte, eine anwendungsspezifische integrierte Schaltung (ASIC) oder eine sonstige programmierbare Schaltung, beispielsweise auch ein Field Programmable Gate Array (FPGA) und/oder eine programmierbare logische Anordnung (PLA).

Die Erfindung betrifft auch eine Messeinrichtung zur Bestimmung eines Wicklungswiderstands einer Wicklung eines Elektromotors eines Elektrowerkzeugs. Die Messeinrichtung weist eine Messeinheit und eine Steuereinrichtung auf. Die Messeinrichtung weist außerdem eine Prüfsignalquelle auf, die mit der Wicklung verbunden ist, um die Wicklung mit einem von der Prüfsignalquelle erzeugten Prüfsignal zu beaufschlagen. Die Messeinheit ist mit der Wicklung zur Erfassung wenigstens eines Messwerts als Reaktion auf die Beaufschlagung der Wicklung mit dem Prüfsignal verbunden. Die Steuereinrichtung ist eingerichtet, um den Wicklungswiderstand unter Berücksichtigung des Prüfsignals und des Messwerts zu bestimmen. Die Prüfsignalquelle ist eingerichtet, das Prüfsignal mit einem alternierenden Verlauf zu erzeugen, wobei die Messeinheit eingerichtet ist, für jede Halbwelle des alterierenden Prüfsignals zumindest einen einzelnen Messwert oder einen aus mehreren einzelnen Messwerten gemittelten Messwert zu erfassen. Weiter ist vorgesehen, dass die Steuereinrichtung eingerichtet ist, für die Bestimmung des Wicklungswiderstand einen differentiellen Messwert aus den für die jeweilige Halbwelle erfassten einzelnen Messwerten oder gemittelten Messwerten zu berechnen.

Durch die erfindungsgemäße Messeinrichtung kann auf vorteilhafte Weise der ohmsche Ständerwiderstand des Elektromotors bzw. einer Statorwicklung des Elektromotors während des Betriebs des Elektromotors bestimmt werden.

Der Elektromotor kann sich während der Beaufschlagung der Wicklung mit dem Prüfsignal vorzugsweise in einem drehenden und gegebenenfalls auch in einem mit Momenten belasteten Zustand befinden.

Der Wicklungswiderstand kann schließlich auf die Ist-Temperatur der Wicklungen bzw. des Elektromotors schließen lassen und/oder auf vorteilhafte Weise zur Bestimmung von Parametern zur Stromregelung herangezogen werden.

Insbesondere hochdynamische Elektromotoren weisen häufig nur sehr geringe Wicklungswiderstände auf, beispielsweise im Milliohmbereich. Die sich temperaturbedingt ergebende Änderung des Wicklungswiderstands kann schließlich vergleichsweise groß sein. Auch eine temperaturbedingte Verdopplung des Wicklungswiderstands ist nicht unüblich, weshalb sich die erfindungsgemäße Bestimmung des Wicklungswiderstands besonders vorteilhaft zur Verwendung mit hochdynamischen Elektromotoren bzw. zur Verwendung mit Elektromotoren mit geringen Wicklungswiderständen eignen kann.

Die Erfindung betrifft schließlich auch ein Elektrowerkzeug, aufweisend einen Elektromotor und eine Messeinrichtung gemäß den vorstehenden und nachfolgenden Ausführungen.

Merkmale, die im Zusammenhang mit dem erfindungsgemäßen Verfahren beschrieben wurden, sind selbstverständlich auch für das Computerprogrammprodukt, die Messeinrichtung und das Elektrowerkzeug vorteilhaft umsetzbar - und umgekehrt. Ferner können Vorteile, die bereits im Zusammenhang mit dem erfindungsgemäßen Verfahren genannt wurden, auch auf das Computerprogrammprodukt, die Messeinrichtung und das Elektrowerkzeug bezogen verstanden werden - und umgekehrt.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielswiese ausschließlich aus den in Anspruch 1 genannten Merkmalen bestehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:

Figur 1     ein Blockschaltbild eines erfindungsgemäßen Elektrowerkzeugs mit einem Elektromotor und einer Messeinrichtung; und

Figur 2    den beispielhaften Verlauf eines Prüfsignals.

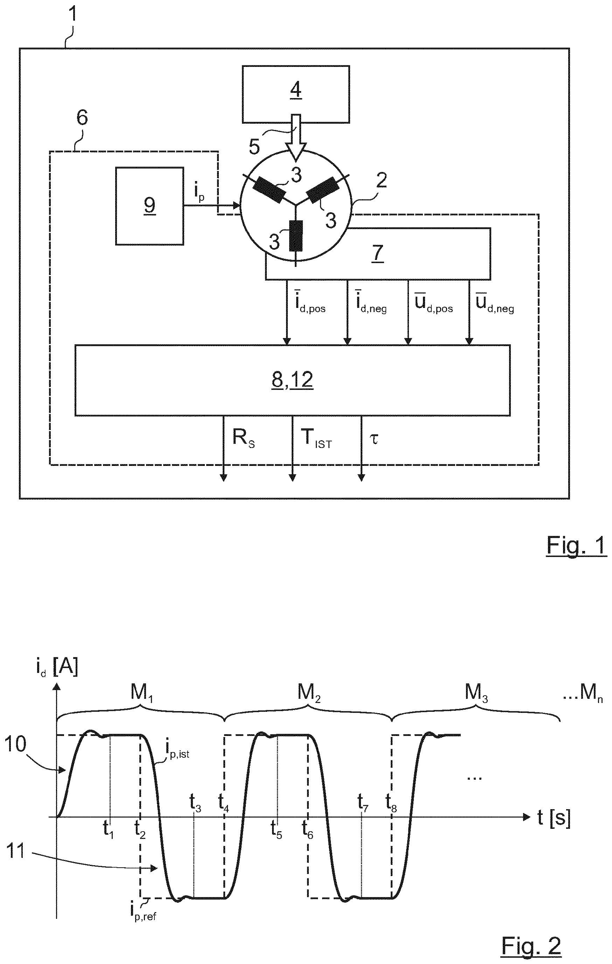

Figur 1 zeigt ein Blockschaltbild eines nicht näher dargestellten Elektrowerkzeugs 1. Das Elektrowerkzeug 1 weist einen Elektromotor 2 auf, der vorzugsweise als Drehstrommaschine ausgebildet ist. Der Elektromotor 2 weist drei Phasen bzw. drei Wicklungen 3 auf, die in Figur 1 vereinfacht angedeutet sind. Ein Motortreiber 4 vermag den Elektromotor 2 bzw. dessen Wicklungen 3 mit einem Betriebssignal 5 zu beaufschlagen. Vorzugsweise ist eine Vektorregelung zum Betrieb des Elektromotors 2 vorgesehen.

Das Elektrowerkzeug 1 weist außerdem eine Messeinrichtung 6 auf. Die Messeinrichtung 6 ist in Figur 1 als strichlinierte Anordnung innerhalb des Elektrowerkzeugs 1 angedeutet. Die Messeinrichtung 6 ist ausgebildet, um einen Wicklungswiderstand Rs einer Wicklung 3 des Elektromotors 2 zu bestimmen. Grundsätzlich können die Wicklungswiderstände Rs jeder der Wicklungen 3 oder auch nur ein Wicklungswiderstand Rs einer einzigen Wicklung 3 bestimmt werden.

Die Messeinrichtung 6 weist eine Messeinheit 7, eine Steuereinrichtung 8 und eine Prüfsignalquelle 9 auf.

Die Prüfsignalquelle 9 ist mit der Wicklung 3 (oder mit den Wicklungen 3) verbunden, um die Wicklung 3 mit einem von der Prüfsignalquelle 9 erzeugten Prüfsignal $i_p$ zu beaufschlagen. Bei dem Prüfsignal $i_p$ handelt es sich vorzugsweise um einen Prüfstrom, dessen Verlauf in Figur 2 angedeutet ist. Das Prüfsignal $i_p$ weist einen alternierenden Verlauf auf. Im Idealfall folgt das Prüfsignal $i_p$ einem rechteckigen Verlauf (vgl. strichlinierte Darstellung $i_{p,ref}$). Vorzugsweise wird das Prüfsignal $i_p$ während des Betriebs des Elektromotors 2 auf das an der Wicklung 3 anliegende Betriebssignal 5 aufmoduliert. Um ein unerwünschtes Pendelmoment auszuschließen, wird das Prüfsignal $i_p$ vorzugsweise ausschließlich in die d-Achse eines d/q-Koordinatensystems eines Permanentmagnet-Synchronmotors eingespeist.

Die Messeinheit 7 ist mit der Wicklung 3 zur Erfassung wenigstens eines Messwerts als Reaktion auf die Beaufschlagung der Wicklung 3 mit dem Prüfsignal $i_p$ verbunden. Vorzugsweise erfasst die Messeinheit 7 wenigstens einen Spannungs-Messwert $u_d$ und wenigstens einen Strom-Messwert $i_d$. Hierdurch kann schließlich die Ständerstrangspannungsgleichung im d/q-Koordinatensystem ausgewertet werden.

Um die Ständerstrangspannungsgleichung zu vereinfachen, kann vorzugsweise von quasistationären Zuständen ausgegangen werden, insofern die Messeinheit 7 die Messung erst nach dem Einschwingen des Prüfsignals $i_p$ durchführt. In Figur 2 ist neben dem Referenzwert $i_{p,ref}$ auch der Ist-Wert $i_{p,ist}$ des Prüfsignals $i_p$ dargestellt. Vorzugsweise führt die Messeinheit 7 die Messungen zunächst zwischen den eingeschwungenen Zeitpunkten $t_1$ und $t_2$ (für die positive Halbwelle 10) und zwischen den eingeschwungenen Zeitpunkten $t_3$ und $t_4$ (für die negative Halbwelle 11) durch. Die Messeinheit 7 vermag für jede Halbwelle 10, 11 des alternierenden Prüfsignals $i_p$ einen aus mehreren einzelnen Messwerten $i_d$, $u_d$ gemittelten Messwert zu erfassen.

Auf diese Weise können ein gemittelter Spannungs-Messwert $\overline{u}_{d,pos}$, $\overline{u}_{d,neg}$ und ein gemittelter Strom-Messwert $\overline{I}_{d,pos}$, $\overline{I}_{d,neg}$ für jede Halbwelle 10, 11 des Prüfsignals $i_p$ ermittelt werden. Die gemittelten Messwerte $\overline{u}_{d,pos}$, $\overline{u}_{d,neg}$, $\overline{I}_{d,pos}$, $\overline{I}_{d,neg}$ können schließlich an die Steuereinrichtung 8 übergeben werden.

Die Steuereinrichtung 8 ist eingerichtet, um den Wicklungswiderstand Rs unter Berücksichtigung der (gemittelten) Messwerte $\overline{u}_{d,pos}$, $\overline{u}_{d,neg}$, $\overline{I}_{d,pos}$, $\overline{I}_{d,neg}$ der Messeinheit 7 zu bestimmen. Die Steuereinrichtung 8 kann hierfür einen differenziellen Messwert aus den für die jeweilige Halbwelle 10, 11 erfassten gemittelten Messwerten $\overline{u}_{d,pos}$, $\overline{u}_{d,neg}$, $\overline{I}_{d,pos}$, $\overline{I}_{d,neg}$ berechnen. Aus den gemittelten Spannungs-Messwerten $\overline{u}_{d,pos}$, $\overline{u}_{d,neg}$ und den gemittelten Strom-Messwerten $\overline{I}_{d,pos}$, $\overline{I}_{d,neg}$ berechnet die Steuereinrichtung 8 somit einen differenziellen Spannungs-Messwert $(\overline{u}_{d,pos} - \overline{u}_{d,neg})$ und jeweilige differenzielle Strom-Messwerte $(\overline{I}_{d,pos} - \overline{I}_{d,neg})$ und $(\overline{I}_{q,pos} - \overline{I}_{q,neg})$. Hierdurch kann schließlich unter Berücksichtigung der Ständerstrangspannungsgleichung für stationäre Zustände der Wicklungswiderstand $R_{S,n}$ des entsprechenden Messintervalls $M_{1...n}$ berechnet werden.

Vorzugsweise werden mehrere Messintervalle $M_{1...n}$ (vgl. Figur 2) ausgewertet und das jeweilige Ergebnis gemittelt, um den finalen Wicklungswiderstand Rs noch genauer zu erfassen.

Die Steuereinrichtung 8 kann außerdem eingerichtet sein, um auf Grundlage des Wicklungswiderstands Rs einen oder mehrere Regelparameter zu berechnen, vorzugsweise eine Zeitkonstante $\tau$ der Wicklung 3.

Außerdem kann die Steuereinrichtung 8 eingerichtet sein, um auf Grundlage des Wicklungswiderstands Rs eine Ist-Temperatur $T_{IST}$ des Elektromotors 2 zu berechnen. Optional kann die Steuereinrichtung 8 schließlich auch eine Temperaturdifferenz zwischen der Ist-Temperatur $T_{IST}$ und einer zu erwartenden Nominaltemperatur erfassen. Hierdurch kann beispielsweise ermittelt werden, ob die Ist-Temperatur $T_{IST}$ im aktuellen Betriebszustand des Elektrowerkzeugs 1 der zu erwartenden Nominaltemperatur entspricht. Mitunter kann es vorkommen, dass beispielsweise Lüftungsschlitze des Elektrowerkzeugs 1 durch Staub oder Schmutz blockiert sind und die Ist-Temperatur $T_{IST}$ des Elektrowerkzeugs 1 dadurch unverhältnismäßig ansteigt. In Abhängigkeit der Temperaturdifferenz kann beispielsweise eine Meldung für einen Benutzer des Elektrowerkzeugs 1 ausgegeben werden, z. B. ein Hinweis, das Elektrowerkzeug 1 zu reinigen. Gegebenenfalls kann das Elektrowerkzeug 1 auch abgeschaltet werden, wenn die Temperaturdifferenz einen vordefinierten Schwellenwert überschreitet.

Ein entsprechendes Verfahren zum Betrieb eines Elektrowerkzeugs 1, wonach die Messeinrichtung 6 den Wicklungswiderstand Rs der Wicklung 3 des Elektromotors 2 des Elektrowerkzeugs 1 bestimmt, kann vorzugsweise als Computerprogrammprodukt mit Programmcodemitteln auf einer Steuereinheit 12 des Elektrowerkzeugs 1 ausgeführt werden.

Die Steuereinheit 12 und die Steuereinrichtung 8 können identisch, gegebenenfalls aber auch unabhängig voneinander sein.

Grundsätzlich sei erwähnt, dass die Messeinheit 7, die Prüfsignalquelle 9 und die Steuereinrichtung 8 nicht zwingend voneinander unabhängige Bauteile bzw. Baugruppen darstellen müssen, sondern auch in beliebigen Kombinationen vorliegen können. Beispielsweise können Verfahrensmerkmale, insbesondere betreffend die Auswertung von Messwerten, die im Rahmen der Messeinheit 7 beschrieben wurden, alternativ auch von der Steuereinrichtung 8 umgesetzt werden - und umgekehrt.

**Patentansprüche**

1. Verfahren zum Betrieb eines Elektrowerkzeugs (1), wonach eine Messeinrichtung (6) einen Wicklungswiderstand (Rs) einer Wicklung (3) eines Elektromotors (2) des Elektrowerkzeugs (1) bestimmt, wobei eine Prüfsignalquelle (9) die Wicklung (3) während des Betriebs des Elektromotors (2) mit einem Prüfsignal ($i_p$) beaufschlagt, wobei eine Messeinheit (7) wenigstens einen Messwert ($u_d$, $i_d$) als Reaktion der Wicklung (3) auf das Prüfsignal ($i_p$) erfasst, und wobei eine Steuereinrichtung (8) den Wicklungswiderstand (Rs) unter Berücksichtigung des Messwerts ($u_d$, $i_d$) bestimmt, wobei die Prüfsignalquelle (9) das Prüfsignal ($i_p$) mit einem alternierenden Verlauf erzeugt, **dadurch gekennzeichnet, dass** die Messeinheit (7) für jede Halbwelle (10, 11) des alterierenden Prüfsignals ($i_p$) zumindest einen einzelnen Messwert ($u_d$, $i_d$) oder einen aus mehreren einzelnen Messwerten ($u_d$, $i_d$) gemittelten Messwert erfasst, wobei die Steuereinrichtung (8) für die Bestimmung des Wicklungswiderstand (Rs) einen differentiellen Messwert aus den für die jeweilige Halbwelle (10, 11) erfassten einzelnen Messwerten ($u_d$, $i_d$) oder gemittelten Messwerten ($\overline{u}_{d,pos}$, $\overline{u}_{d,neg}$, $\overline{I}_{d,pos}$, $\overline{I}_{d,neg}$) berechnet.

2. Verfahren nach Anspruch 1, **dadurch gekennzeichnet, dass** die Prüfsignalquelle (9) das Prüfsignal ($i_p$) auf ein an der Wicklung (3) anliegendes Betriebssignal (5) aufmoduliert.

3. Verfahren nach Anspruch 1 oder 2, **dadurch gekennzeichnet, dass** die Prüfsignalquelle (9) das Prüfsignal ($i_p$) ausschließlich in die d-Achse eines d/q-Koordinatensystems einprägt.

4. Verfahren nach einem der Ansprüche 1 bis 3, **dadurch gekennzeichnet, dass** die Messeinheit (7) wenigstens einen Spannungs-Messwert ($u_d$) und wenigstens einen Strom-Messwert ($i_d$) erfasst.

5. Verfahren nach einem der Ansprüche 1 bis 4, **dadurch gekennzeichnet, dass** die von der Messeinheit (7) für jede Halbwelle (10, 11) des alterierenden Prüfsignals ($i_p$) erfassten, aus mehreren einzelnen Messwerten ($u_d$, $i_d$) gemittelten Messwerte ein gemittelter Spannungs-Messwert ($\overline{u}_{d,pos}$, $\overline{u}_{d,neg}$) und ein gemittelter Strom-Messwert ($\overline{I}_{d,pos}$, $\overline{I}_{d,neg}$) sind.

6. Verfahren nach einem der Ansprüche 1 bis 5, **dadurch gekennzeichnet, dass** die von der Steuereinrichtung (8) für die Bestimmung des Wicklungswiderstand (Rs) aus den für die jeweilige Halbwelle (10, 11) erfassten einzelnen Messwerten ($u_d$, $i_d$) oder gemittelten Messwerten ($\overline{u}_{d,pos}$, $\overline{u}_{d,neg}$, $\overline{I}_{d,pos}$, $\overline{I}_{d,neg}$) berechneten differentiellen Messwerte ein differentieller Spannungs-Messwert und ein differentieller Strom-Messwert sind.

7. Verfahren nach einem der Ansprüche 1 bis 6, **dadurch gekennzeichnet, dass** die Steuereinrichtung (8) auf Grundlage des Wicklungswiderstands (Rs) einen oder mehrere Regelparameter berechnet.

**8.** Verfahren nach Anspruch 7,
**dadurch gekennzeichnet, dass** wenigstens einer der berechneten Regelparameter eine Zeitkonstante ($\tau$) der Wicklung (3) ist.

**9.** Verfahren nach einem der Ansprüche 1 bis 8,
**dadurch gekennzeichnet, dass** die Steuereinrichtung (8) auf Grundlage des Wicklungswiderstands (Rs) eine Ist-Temperatur ($T_{IST}$) des Elektromotors (2) berechnet.

**10.** Verfahren nach Anspruch 9,
**dadurch gekennzeichnet, dass** die Steuereinrichtung (8) eine Temperaturdifferenz zwischen der Ist-Temperatur ($T_{IST}$) und einer zu erwartenden Nominaltemperatur erfasst.

**11.** Verfahren nach Anspruch 10,
**dadurch gekennzeichnet, dass** in Abhängigkeit der Temperaturdifferenz eine Meldung für einen Benutzer des Elektrowerkzeugs (1) ausgegeben wird.

**12.** Verfahren nach Anspruch 10 oder 11,
**dadurch gekennzeichnet, dass** das Elektrowerkzeug (1) abgeschaltet wird, wenn die Temperaturdifferenz einen vordefinierten Schwellenwert überschreitet.

**13.** Computerprogrammprodukt mit Programmcodemitteln, um ein Verfahren gemäß einem der Ansprüche 1 bis 12 durchzuführen, wenn das Programm auf einer Steuereinheit (12) eines Elektrowerkzeugs (1) ausgeführt wird.

**14.** Messeinrichtung (6) zur Bestimmung eines Wicklungswiderstands (Rs) einer Wicklung (3) eines Elektromotors (2) eines Elektrowerkzeugs (1), aufweisend eine Messeinheit (7) und eine Steuereinrichtung (8), wobei eine Prüfsignalquelle (9) vorgesehen und mit der Wicklung (3) verbindbar ist, um die Wicklung (3) mit einem von der Prüfsignalquelle (9) erzeugten Prüfsignal ($i_p$) zu beaufschlagen, wobei die Messeinheit (7) mit der Wicklung (3) zur Erfassung wenigstens eines Messwerts ($u_d$, $i_d$) als Reaktion auf die Beaufschlagung der Wicklung (3) mit dem Prüfsignal ($i_p$) verbindbar ist, und wobei die Steuereinrichtung (8) eingerichtet ist, um den Wicklungswiderstand (Rs) unter Berücksichtigung des Messwerts ($u_d$, $i_d$) zu bestimmen, wobei die Prüfsignalquelle (9) eingerichtet ist, das Prüfsignal ($i_p$) mit einem alternierenden Verlauf zu erzeugen,
**dadurch gekennzeichnet, dass** die Messeinheit (7) eingerichtet ist, für jede Halbwelle (10, 11) des alterierenden Prüfsignals ($i_p$) zumindest einen einzelnen Messwert ($u_d$, $i_d$) oder einen aus mehreren einzelnen Messwerten ($u_d$, $i_d$) gemittelten Messwert zu erfassen, wobei die Steuereinrichtung (8) eingerichtet ist, für die Bestimmung des Wicklungswiderstand (Rs) einen differentiellen Messwert aus den für die jeweilige Halbwelle (10, 11) erfassten einzelnen Messwerten ($u_d$, $i_d$) oder gemittelten Messwerten ($\overline{u}_{d,pos}$, $\overline{u}_{d,neg}$, $\overline{I}_{d,pos}$, $\overline{I}_{d,neg}$) zu berechnen.

**15.** Elektrowerkzeug (1), aufweisend einen Elektromotor (2) und eine Messeinrichtung (6) nach Anspruch 14.


**Claims**

**1.** A method for operating an electric tool (1), according to which a measuring device (6) determines a winding resistance (Rs) of a winding (3) of an electric motor (2) of the electric tool (1), a test signal source (9) applying a test signal ($i_p$) to the winding (3) during the operation of the electric motor (2), a measuring unit (7) detecting at least one measured value ($u_d$, $i_d$) as a reaction of the winding (3) to the test signal ($i_p$) and a control device (8) determining the winding resistance (Rs) taking into account the measured value ($u_d$, $i_d$), the test signal source (9) generating the test signal ($i_p$) with an alternating curve, **characterised in that** the measuring unit (7) detects at least one individual measured value ($u_d$, $i_d$) or a measured value averaged from a plurality of individual measured values ($u_d$, $i_d$) for each half-wave (10, 11) of the alternating test signal ($i_p$) the control device (8) calculating a differential measured value from the individual measured values ($u_d$, $i_d$) or averaged measured values ($\overline{u}_{d,pos}$, $\overline{u}_{d,neg}$, $\overline{I}_{d,pos}$, $\overline{I}_{d,neg}$) recorded for the respective half-wave (10, 11) for determining the winding resistance (Rs).

**2.** The method according to claim 1,
**characterised in that** the test signal source (9) modulates the test signal ($i_p$) onto an operating signal (5) applied to the winding (3).

3. The method according to claim 1 or 2,
   **characterised in that** the test signal source (9) impresses the test signal ($i_p$) exclusively in the d-axis of a d/q coordinate system.

4. The method according to one of the claims 1 to 3,
   **characterised in that** the measuring unit (7) detects at least one voltage measured value ($u_d$) and at least one current measured value ($i_d$).

5. The method according to one of the claims 1 to 4,
   **characterised in that** the measured values detected by the measuring unit (7) for each half-wave (10, 11) of the alternating test signal ($i_p$) and averaged from a plurality of individual measured values ($u_d$, $i_d$) are an averaged voltage measured value ($\overline{u}_{d,pos}$, $\overline{u}_{d,neg}$) and an averaged current measured value ($\overline{I}_{d,pos}$, $\overline{I}_{d,neg}$).

6. The method according to one of claims 1 to 5,
   **characterised in that** the differential measured values calculated by the control device (8) for determining the winding resistance (Rs) from the individual measured values ($u_d$, $i_d$) or averaged measured values ($\overline{u}_{d,pos}$, $\overline{u}_{d,neg}$, $\overline{I}_{d,pos}$, $\overline{I}_{d,neg}$) detected for the respective half-wave (10, 11) are a differential voltage measured value and a differential current measured value.

7. The method according to any one of claims 1 to 6,
   **characterized in that** the control means (8) calculates one or more control parameters based on the winding resistance (Rs).

8. The method according to claim 7,
   **characterised in that** at least one of the calculated control parameters is a time constant ($\tau$) of the winding (3).

9. The method according to one of claims 1 to 8,
   **characterised in that** the control device (8) calculates an actual temperature ($T_{IST}$) of the electric motor (2) on the basis of the winding resistance (Rs).

10. The method according to claim 9,
    **characterised in that** the control device (8) detects a temperature difference between the actual temperature ($T_{IST}$) and an expected nominal temperature.

11. The method according to claim 10,
    **characterised in that** a message for a user of the power tool (1) is output as a function of the temperature difference.

12. The method according to claim 10 or 11,
    **characterised in that** the power tool (1) is switched off when the temperature difference exceeds a predefined threshold value.

13. A computer program product comprising program code means for performing a method according to any one of claims 1 to 12 when the program is executed on a control unit (12) of a power tool (1).

14. A measuring device (6) for determining a winding resistance (Rs) of a winding (3) of an electric motor (2) of an electric tool (1), comprising a measuring unit (7) and a control device (8), wherein a test signal source (9) is provided and connectable to the winding (3) for applying a test signal ($i_p$) generated by the test signal source (9) to the winding (3), the measuring unit (7) being connectable to the winding (3) for detecting at least one measured value ($u_d$, $i_d$) in response to the application of the test signal ($i_p$) to the winding (3), and the control device (8) being set up to determine the winding resistance (Rs) taking into account the measured value ($u_d$, $i_d$), the test signal source (9) being set up to generate the test signal ($i_p$) with an alternating curve,
    **characterized in that** the measuring unit (7) is set up to detect at least one individual measured value ($u_d$, $i_d$) or a measured value averaged from a plurality of individual measured values ($u_d$, $i_d$) for each half-wave (10, 11) of the alternating test signal ($i_p$), the control device (8) being set up to calculate a differential measured value from the individual measured values ($u_d$, $i_d$) or averaged measured values ($\overline{u}_{d,pos}$, $\overline{u}_{d,neg}$, $\overline{I}_{d,pos}$, $\overline{I}_{d,neg}$) recorded for the respective half-wave (10, 11) in order to determine the winding resistance (Rs).

**15.** A power tool (1) comprising an electric motor (2) and a measuring device (6) according to claim 14.

**Revendications**

**1.** Procédé de fonctionnement d'un outil électrique (1), selon lequel un dispositif de mesure (6) détermine une résistance de bobinage (Rs) d'un bobinage (3) d'un moteur électrique (2) de l'outil électrique (1), une source de signal de test (9) appliquant un signal de test ($i_p$) au bobinage (3) pendant le fonctionnement du moteur électrique (2), une unité de mesure (7) détectant au moins une valeur de mesure ($u_d$, $i_d$) en tant que réaction de l'enroulement (3) au signal de test ($i_p$), et un dispositif de commande (8) déterminant la résistance d'enroulement (Rs) en tenant compte de la valeur de mesure ($u_d$, $i_d$), la source de signal de test (9) produisant le signal de test ($i_p$) avec une allure alternée, **caractérisé en ce que** l'unité de mesure (7) saisit pour chaque demi-onde (10, 11) du signal de test alternant ($i_p$) au moins une valeur de mesure individuelle ($u_d$, $i_d$) ou une valeur de mesure moyennée à partir de plusieurs valeurs de mesure individuelles ($u_d$, $i_d$), le dispositif de commande (8) calculant, pour la détermination de la résistance d'enroulement (Rs), une valeur de mesure différentielle à partir des valeurs de mesure individuelles ($u_d$, $i_d$) ou des valeurs de mesure moyennées ($\overline{u}_{d,pos}$, $\overline{u}_{d,neg}$, $\overline{I}_{d,pos}$, $\overline{I}_{d,neg}$) saisies pour la demi-onde (10, 11) correspondante.

**2.** Procédé selon la revendication 1,
**caractérisé en ce que** la source de signal de test (9) module le signal de test ($i_p$) sur un signal de fonctionnement (5) appliqué à l'enroulement (3).

**3.** Procédé selon la revendication 1 ou 2,
**caractérisé en ce que** la source de signal de test (9) imprime le signal de test ($i_p$) exclusivement sur l'axe d d'un système de coordonnées d/q.

**4.** Procédé selon l'une des revendications 1 à 3,
**caractérisé en ce que** l'unité de mesure (7) détecte au moins une valeur de mesure de tension ($u_d$) et au moins une valeur de mesure de courant ($i_d$).

**5.** Procédé selon l'une des revendications 1 à 4,
**caractérisé en ce que** les valeurs de mesure saisies par l'unité de mesure (7) pour chaque demi-onde (10, 11) du signal de test alternant ($i_p$) et moyennées à partir de plusieurs valeurs de mesure individuelles ($u_d$, $i_d$) sont une valeur de mesure de tension moyenne ($\overline{u}_{d,pos}$, $\overline{u}_{d,neg}$) et une valeur de mesure de courant moyenne ($\overline{I}_{d,pos}$, $\overline{I}_{d,neg}$).

**6.** Procédé selon l'une quelconque des revendications 1 à 5,
**caractérisé en ce que** les valeurs de mesure différentielles calculées par le dispositif de commande (8) pour la détermination de la résistance du bobinage (Rs) à partir des valeurs de mesure individuelles ($u_d$, $i_d$) ou des valeurs de mesure moyennes ($\overline{u}_{d,pos}$, $\overline{u}_{d,neg}$, $\overline{I}_{d,pos}$, $\overline{I}_{d,neg}$) détectées pour chaque demi-onde (10, 11) sont une valeur de mesure différentielle de tension et une valeur de mesure différentielle de courant.

**7.** Procédé selon l'une des revendications 1 à 6,
**caractérisé en ce que** le dispositif de commande (8) calcule un ou plusieurs paramètres de régulation sur la base de la résistance d'enroulement (Rs).

**8.** Procédé selon la revendication 7,
**caractérisé en ce qu'**au moins un des paramètres de régulation calculés est une constante de temps ($\tau$) du bobinage (3).

**9.** Procédé selon l'une des revendications 1 à 8,
**caractérisé en ce que** le dispositif de commande (8) calcule une température réelle ($T_{IST}$) du moteur électrique (2) sur la base de la résistance de l'enroulement (Rs).

**10.** Procédé selon la revendication 9,
**caractérisé en ce que** le dispositif de commande (8) détecte une différence de température entre la température réelle ($T_{IST}$) et une température nominale attendue.

**11.** Procédé selon la revendication 10,
**caractérisé en ce que**, en fonction de la différence de température, un message est émis pour un utilisateur de l'outil électrique (1).

**12.** Procédé selon la revendication 10 ou 11,
**caractérisé en ce que** l'outil électrique (1) est arrêté lorsque la différence de température dépasse une valeur seuil prédéfinie.

**13.** Produit programme d'ordinateur comprenant des moyens de codage de programme pour mettre en oeuvre un procédé selon l'une quelconque des revendications 1 à 12, lorsque le programme est exécuté sur une unité de commande (12) d'un outil électrique (1).

**14.** Dispositif de mesure (6) pour déterminer une résistance de bobinage (Rs) d'un bobinage (3) d'un moteur électrique (2) d'un outil électrique (1), présentant une unité de mesure (7) et un dispositif de commande (8), une source de signal de test (9) étant prévue et connectable au bobinage (3) pour appliquer au bobinage (3) un signal de test ($i_p$) généré par la source de signal de test (9), l'unité de mesure (7) étant connectable à l'enroulement (3) pour détecter au moins une valeur de mesure ($u_d$, $i_d$) en réaction à l'alimentation de l'enroulement (3) avec le signal de test ($i_p$) et le dispositif de commande (8) étant conçu pour déterminer la résistance de l'enroulement (Rs) en tenant compte de la valeur de mesure ($u_d$, $i_d$), la source de signal de test (9) étant conçue pour générer le signal de test ($i_p$) avec une allure alternée,
**caractérisé en ce que** l'unité de mesure (7) est agencée pour saisir, pour chaque demi-onde (10, 11) du signal de test alternant ($i_p$), au moins une valeur de mesure individuelle ($u_d$, $i_d$) ou une valeur de mesure moyennée à partir de plusieurs valeurs de mesure individuelles ($u_d$, $i_d$), le dispositif de commande (8) étant agencé, pour la détermination de la résistance d'enroulement (Rs), de calculer une valeur de mesure différentielle à partir des valeurs de mesure individuelles ($u_d$, $i_d$) ou des valeurs de mesure moyennes ($\overline{u}_{d,pos}$, $\overline{u}_{d,neg}$, $\overline{I}_{d,pos}$, $\overline{I}_{d,neg}$) saisies pour la demi-onde respective (10, 11).

**15.** Outil électrique (1) comprenant un moteur électrique (2) et un dispositif de mesure (6) selon la revendication 14.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 60223466 T2
- EP 0414052 B1

- EP 0720266 A1